# EUROPÄISCHE PATENTSCHRIFT

(11) **EP 3 093 372 B1**
(45) Veröffentlichungstag und Bekanntmachung des Hinweises auf die Patenterteilung: **29.04.2020**
(21) Anmeldenummer: 16167274.6
(22) Anmeldetag: 27.04.2016
(51) Int. Cl.: C23C 28/00, C23C 14/04, F01D 5/28, F01D 11/12

(54) **ABDECKVERFAHREN ZUR HERSTELLUNG EINER KOMBINATION VON SCHAUFELSPITZENPANZERUNG UND EROSIONSSCHUTZSCHICHT**
COATING METHOD FOR PRODUCING A COMBINATION OF ARMOR PLATING FOR A BLADE TIP AND EROSION RESISTANT COATING
PROCEDE DE RECOUVREMENT DESTINE A PRODUIRE UNE COMBINAISON DE BLINDAGE D'EXTREMITE D'AUBES ET COUCHE DE PROTECTION CONTRE L'EROSION

(30) Priorität: 12.05.2015 DE 102015208783
(43) Veröffentlichungstag der Anmeldung: 16.11.2016
(73) Patentinhaber: MTU Aero Engines AG, 80995 München (DE)
(72) Erfinder: Uihlein, Thomas, 85221 Dachau (DE); Stolle, Ralf, 82515 Wolfratshausen (DE)

(56) Entgegenhaltungen:
- EP-A1- 1 352 988
- EP-A2- 1 085 171
- EP-A2- 2 031 186
- EP-A2- 2 317 078
- WO-A1-2014/126732
- DE-A1-102005 060 712
- US-A1- 2013 230 402

## Beschreibung

### HINTERGRUND DER ERFINDUNG

### GEBIET DER ERFINDUNG

Die vorliegende Erfindung betrifft ein Verfahren zur Herstellung einer Schaufel für eine Strömungsmaschine, wobei die Schaufel an ihrer Schaufelspitze eine Schaufelspitzenpanzerung und zumindest an ihrem Schaufelblatt eine Erosionsschutzschicht aufweist.

### STAND DER TECHNIK

Strömungsmaschinen, wie stationäre Gasturbinen oder Flugtriebwerke, weisen unter anderem eine Vielzahl von Schaufeln auf, die an einem Rotor drehbar angeordnet sind, um entweder das Fluid, welches durch die Strömungsmaschine fließt, zu verdichten oder durch das Fluid zur Drehung angetrieben zu werden.

Um die Strömungsverluste zwischen den sich drehenden Schaufeln und einer umgebenden Strömungskanalbegrenzung zu minimieren, muss der Spalt zwischen den Schaufelspitzen am radialen Ende der Schaufeln und der Strömungskanalbegrenzung möglichst klein sein, sodass möglichst wenig Fluid durch den Spalt zwischen Strömungskanalbegrenzung und Schaufeln fließen kann.

Aus diesem Grund werden bei bekannten Strömungsmaschinen zur Abdichtung zwischen den Schaufelspitzen und der Strömungskanalbegrenzung sogenannte Labyrinthdichtungen vorgesehen, bei welchen die Schaufelspitzen sich in einer Nut bewegen, die sich beim Betrieb der Strömungsmaschine in einem Dichtungsmaterial an der Strömungskanalbegrenzung durch entsprechendes Einschleifen der Schaufelspitzen ausbildet. Entsprechend ist es auch bekannt an den Schaufelspitzen so genannte Schaufelspitzenpanzerungen vorzusehen, die in einer Metall - Matrix eingelagerte Hartstoffpartikel aufweisen, um mittels der Hartstoffpartikel die Nut für die Labyrinthdichtung im gegenüberliegenden Dichtungsmaterial der Strömungskanalbegrenzung einzuschneiden und die Schaufelspitze vor Verschleiß zu schützen.

Darüber hinaus umfassen Schaufeln von Strömungsmaschinen zusätzlich am Schaufelblatt Schutzbeschichtungen, wie Erosionsschutzschichten, um das Schaufelmaterial im Bereich des Schaufelblatts ebenfalls vor Verschleiß, beispielsweise durch Erosion, zu schützen.

Entsprechend ist es erforderlich, an einer Schaufel für eine Strömungsmaschine unterschiedliche Beschichtungen nebeneinander anzuordnen, wie beispielsweise eine Spitzenpanzerung an den Schaufelspitzen und eine Erosionsschutzbeschichtung am Schaufelblatt, wobei jedoch vermieden werden muss, dass eine der Beschichtungen und insbesondere die Schaufelspitzenpanzerung von der anderen Beschichtung, nämlich der Erosionsschutzschicht, überdeckt wird, da die überdeckte Schicht, also z.B. die Schaufelspitzenpanzerung, dann ihre Funktion nicht mehr in der gewünschten Art und Weise erfüllen kann. Vielmehr kann es beim Versagen der Schneidfunktion der Schaufelspitzenpanzerung zu massiven Schaufelbeschädigung durch zu hohe thermische und mechanische Lasten kommen.

Entsprechend müssen die einzelnen Schichten in geeigneter Weise nacheinander aufgebracht werden, ohne dass es zu einer unerwünschten Überdeckung der Schichten kommt.

Aus der DE 10 2010 049 398 A1 ist eine verschleiß- und oxidationsbeständige Turbinenschaufel bekannt, die eine oxidationsbeständige, metallische Schicht umfasst, insbesondere eine MCrAlY - Schicht, wobei M ein Metall, insbesondere Nickel, Kobalt oder eine Kombination daraus ist, und die zusätzlich eine keramische Wärmedämmschicht aufweisen kann. Zusätzlich zu dieser oxidationsbeständigen Schutzschicht ist an der Schaufelspitze eine mittels Laserauftragsschweißen aufgebrachte Schutzschicht aus Abrasivmaterial und Bindematerial vorgesehen. Zunächst wird die oxidationsbeständige Schutzschicht in Form der MCrAlY - Schicht vollflächig auf die Schaufel aufgebracht. Die MCrAlY - Schicht wird im Bereich der Schaufelspitze wieder mechanisch entfernt und anschließend wird im Bereich der Schaufelspitze mittels Laserauftragsschweißen die verschleißbeständige Schutzschicht an der Schaufelspitze aufgebracht.

Dieses Verfahren ist sehr aufwändig und fehleranfällig, da beim Entfernen der oxidationsbeständigen Schutzschicht im Bereich der Schaufelspitze die Schutzschicht auch weitergehend beschädigt werden kann. Außerdem kann es beim Laserauftragsschweißen auch zu einer Beschädigung beziehungsweise Überdeckung der Oxidationsschutzschicht kommen.

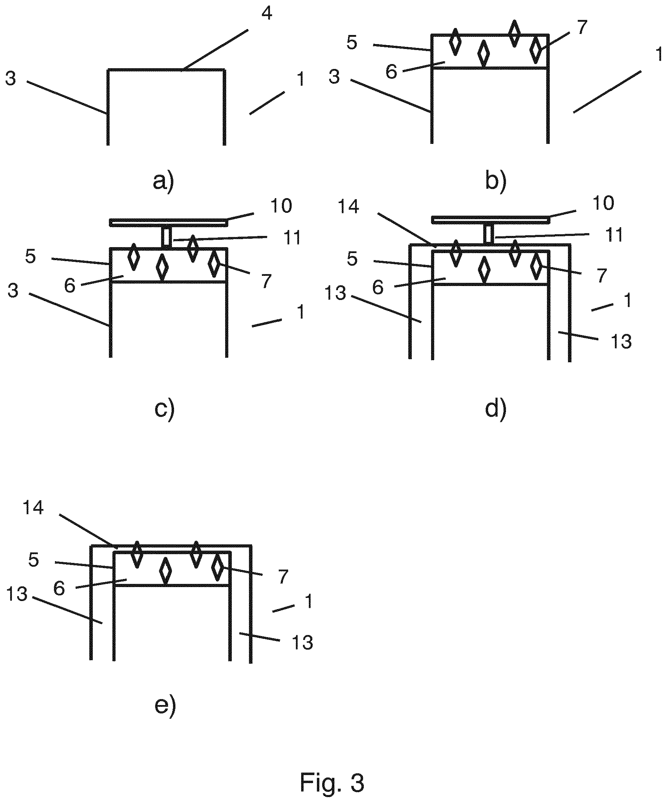

In der Veröffentlichung K.C. Antony ET AL: "Aircraft Gas Turbine Blade and Vane Repair", Superalloys 1988 (Sixth International Symposium), 1. Januar 1988, ist in Abbildung 3c ein Turbinenschaufelblatt dargestellt, auf deren Spitze eine aufgelötete Panzerung und an deren Seiten eine MCrAlY und/ oder TBC angeordnet ist. Dort ist beschrieben, dass früher im Stand der Technik die Panzerung zuerst abgeschieden wurde, anschließend die Spitze maskiert und dann das Schaufelblatt beschichtet wurde. Aus der US-Patentanmeldung US 2013/0230402 A1 ist es bekannt, zum Erhalten einer reduzierten Schichtdicke an der Spitze eines Schaufelblatts eine Schattenmaske zum Maskieren des Bereichs an der Spitze während des Beschichtungsvorgangs zu verwenden.

### OFFENBARUNG DER ERFINDUNG

### AUFGABE DER ERFINDUNG

Es ist somit Aufgabe der vorliegenden Erfindung ein Verfahren zur Herstellung einer Schaufel für eine Strömungsmaschine bereitzustellen, bei der in einfacher und zuverlässiger Weise mindestens zwei unterschiedliche Beschichtungen auf der Schaufel angeordnet werden können, ohne dass die Funktion und Qualität der einzelnen Beschichtungen gegenseitig beeinträchtigt wird. Insbesondere besteht die Aufgabe darin, für eine Schaufel einer Strömungsmaschine eine Schaufelspitzenpanzerung neben einer Erosionsschutzschicht in einer effizienten Weise aufzubringen, wobei die Erosionsschutzschicht insbesondere keine Überdeckung der Schaufelspitzenpanzerung und somit Beeinträchtigung der Funktionsweise der Schaufelspitzenpanzerung bewirken soll.

### TECHNISCHE LÖSUNG

Die oben genannte Aufgabenstellung wird durch ein Verfahren mit den Merkmalen des Anspruchs 1 gelöst. Vorteilhafte Ausgestaltungen sind Gegenstand der abhängigen Ansprüche. Die Erfindung schlägt vor, bei einem Verfahren zur Herstellung einer Schaufel für eine Strömungsmaschine zunächst eine Schaufelspitzenpanzerung an der Schaufelspitze aufzubringen und anschließend im Bereich der Schaufelspitzenpanzerung eine Maske anzuordnen, die die Schaufelspitzenpanzerung bei der nachfolgenden Abscheidung einer Erosionsschutzschicht abdeckt, sodass zumindest die Dicke der im Bereich der Schaufelspitzenpanzerung abgeschiedenen Erosionsschutzschicht soweit verringert wird, dass diese keine nachteiligen Eigenschaften für die Funktionsweise der Schaufelspitzenpanzerung aufweist.

Dabei wird die Maske im Abstand zur Schaufelspitzenpanzerung angeordnet, sodass bei der Abscheidung der Erosionsschutzschicht sich kein Übergang der Erosionsschutzschicht von der an Schaufel anliegenden Erosionsschutzschicht zur Erosionsschutzschicht, die auf der Maske ausgebildet wird, ergibt. Dadurch kann vermieden werden, dass beim späteren Entfernen der Maske die Erosionsschutzschicht beschädigt wird und es insbesondere zur Ablösung der Erosionsschutzschicht außerhalb der Bereiche der Maske kommt, sodass dadurch ungeschützte Bereiche an der Schaufel entstehen würden. Durch die Anordnung der Maske im Abstand zur Schaufelspitzenpanzerung und somit zur Schaufel insgesamt ergibt sich vielmehr ein kontinuierlicher Übergang der Erosionsschutzsicht vom Schaufelblatt zur Schaufelspitzenpanzerung, wobei die Schaufelspitzenpanzerung zumindest teilweise von der Erosionsschutzschicht bedeckt sein kann. Durch die Abdeckung der Schaufelspitzenpanzerung mit der Maske während der Abscheidung der Erosionsschutzschicht wird jedoch die Dicke der Erosionsschutzschicht im Bereich der Schaufelspitzenpanzerung bzw. in Richtung des Bereichs der Schaufelspitzenpanzerung deutlich reduziert, sodass die Wirkung der Schaufelspitzenpanzerung zumindest nach einer kurzen Einsatzdauer, bei der die dünne Erosionsschutzschicht im Bereich der Schaufelspitzenpanzerung beseitigt wird, voll zur Geltung kommen kann. Durch den kontinuierlichen Übergang von einer dicken Erosionsschutzschicht im Bereich des Schaufelblatts zu einer dünnen Erosionsschutzschicht im Bereich der Schaufelspitzenpanzerung, wobei die Dicke der Erosionsschutzsicht im Bereich der Schaufelspitzenpanzerung auch gegen Null gehen kann, wird somit sichergestellt, dass keine ungeschützten Bereiche an der Schaufel vorliegen. Darüber hinaus wird durch den kontinuierlichen Übergang mit der Abnahme der Dicke der Erosionsschutzschicht zur Schaufelspitzenpanzerung hin auch sichergestellt, dass die Haftung der Erosionsschutzsicht gewährleistet ist, während gleichzeitig die Funktion der Schaufelspitzenpanzerung beibehalten wird.

Die verwendeten relativen Begriffe hinsichtlich der Erosionsschutzschicht, wie dünn oder dick bzw. dünner oder dicker, beziehen sich jeweils auf einen Vergleich zu den entsprechenden Bereichen der Erosionsschutzschicht im Bereich des Schaufelblatts und im Bereich der Schaufelspitze bzw. Schaufelspitzenpanzerung, sodass der Begriff der dicken Erosionsschutzschicht im Bereich des Schaufelblatts lediglich angibt, dass die Schichtdicke dort größer ist als im Bereich der Schaufelspitzenpanzerung und umgekehrt.

Die Form der Maske, mit der die Schaufelspitzenpanzerung abgedeckt wird, ist so gewählt, dass sie der Form der Schaufelspitze bzw. der Oberfläche oder Oberseite der Schaufelspitze bzw. der Schaufelspitzenpanzerung nachgebildet ist, sie kann dieser auch entsprechen.

Die Nachbildung kann sowohl zweidimensional als auch dreidimensional sein, wobei eine zweidimensionale Nachbildung durch eine Projektion der Oberflächenform der Schaufelspitze bzw. Schaufelspitzenpanzerung auf eine Ebene realisiert werden kann.

Die Form und/oder Dimensionierung der Maske kann so gewählt sein, dass die Maske teilweise oder ganz über den Bereich der Schaufelspitzenpanzerung bzw. der Schaufelspitze übersteht oder die Maske kann auch entsprechend kleiner gewählt werden, um einen größeren Überlappungsbereich von Schaufelspitzenpanzerung und Erosionsschutzschicht zu erzielen. Darüber hinaus kann auch der Abstand mit dem die Maske gegenüber der Schaufelspitzenpanzerung bzw. der Schaufelspitze angeordnet ist, variiert werden, um die Dicke der abgeschiedenen Erosionsschutzschicht im Bereich der Schaufelspitzenpanzerung und/oder den Übergang der Erosionsschutzschicht von dem Schaufelblatt zur Schaufelspitze zu beeinflussen.

Die Maske kann im Bereich der Eintrittskante und/oder der Austrittskante der Schaufel in geeigneten Halterungen, wie beispielsweise Stützen gelagert sein. Darüber hinaus kann die Maske in einem generativen Herstellungsverfahren, bei dem die Maske und/oder entsprechende Halterungen schichtweise aus Pulvermaterial erzeugt werden, wie beispielsweise durch selektives Laserschmelzen, selektives Elektronenstrahlschmelzen oder dergleichen hergestellt werden, da damit eine einfache Herstellung einer filigranen Struktur ermöglicht wird.

Die Maske und insbesondere ihre Dicke kann so dimensioniert werden, dass die Maske eine ausreichende Stabilität, insbesondere hinsichtlich der Einflüsse bei der nachfolgenden Abscheidung der Erosionsschutzschicht, aufweist und insbesondere durch Temperatureinflüsse und sich daraus ergebende Temperaturschwankungen und dergleichen nicht verformt wird.

Die Maske kann so dimensioniert und/oder angordnet werden, dass die Erosionsschutzschicht im Bereich der Schaufelspitzenpanzerung eine maximale oder mittlere Dicke aufweist, die kleiner als die Hälfte, vorzugsweise kleiner oder gleich einem Drittel, insbesondere kleiner oder gleich 10 % der mittleren Dicke der übrigen Erosionsschutzschicht, insbesondere der Erosionsschutzschicht im Bereich des Schaufelblatts, ist.

Die Schaufelspitzenpanzerung kann durch jedes geeignete Verfahren aufgebracht werden, beispielsweise durch galvanisches Abscheiden von beispielsweise einer Nickel-Matrix mit darin eingelagerten Hartstoffpartikeln, wie Partikeln aus Bornitrid, oder durch Auflöten bzw. durch Aufbringen einer Schlickerschicht.

Die Erosionsschutzschicht kann durch physikalische Dampfphasenabscheidung (physical vapor deposition PVD) abgeschieden werden, wobei insbesondere Aufdampfen, Lichtbogenverdampfen, Elektronenstrahlverdampfen, Zerstäuben (Sputtern) und/oder Magnetron - Sputtern eingesetzt werden können.

### KURZBESCHREIBUNG DER FIGUREN

Die beigefügten Zeichnungen zeigen in rein schematischer Weise in
- Figur 1: eine perspektivische Ansicht einer Schaufel, wie sie in Strömungsmaschinen eingesetzt werden kann, mit einer Maske zur Abscheidung einer Erosionsschutzschicht,
- Figur 2: eine Draufsicht auf das Schaufelblatt der Schaufel gemäß Figur 1 mit der darüber angeordneten Maske ohne Schaufelfuß und in
- Figur 3: in den Teilbildern a) bis e) einen Teil einer Turbinenschaufel nach verschiedenen Verfahrensschritten des erfindungsgemäßen Verfahrens.

### AUSFÜHUNGSBEISPIELE

Weitere Vorteile, Kennzeichen und Merkmale der vorliegenden Erfindung werden bei der nachfolgenden detaillierten Beschreibung von Ausführungsbeispielen deutlich. Allerdings ist die Erfindung nicht auf diese Ausführungsbeispiele beschränkt.

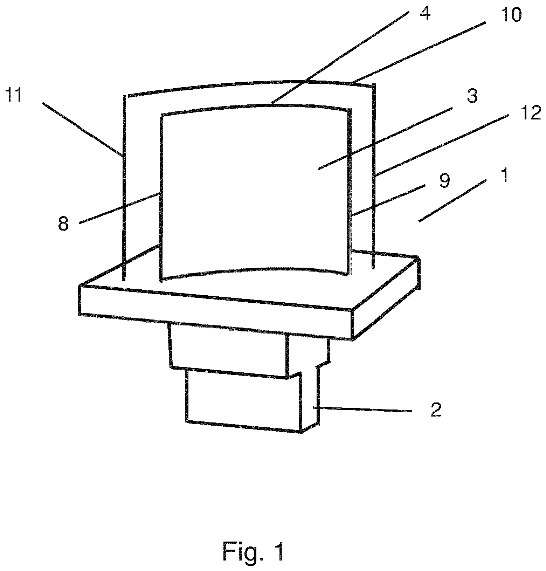

Die Figur 1 zeigt in einer rein schematischen Weise eine perspektivische Ansicht einer Schaufel, wie sie in einer Strömungsmaschine, wie beispielsweise einer stationären Gasturbine oder einem Flugtriebwerk eingesetzt werden kann. Die Schaufel 1 weist einen Schaufelfuß 2 auf, der in eine Scheibe eingesetzt werden kann, die mit einer Welle der Strömungsmaschine dreht. Die Schaufel 1 weist weiterhin ein Schaufelblatt 3 auf, welches im Strömungskanal der Strömungsmaschine angeordnet ist und entweder das Fluid, das durch die Strömungsmaschine fließt, verdichtet oder durch das vorbeiströmende Fluid angetrieben wird. An dem radial außenliegenden Ende der Schaufel 1 befindet sich die sogenannte Schaufelspitze 4, die zur Vermeidung von Strömungsverlusten möglichst eng an einem umgebenden Strömungskanalgehäuse anliegt oder sich in dieses sogar einschleift. Zu diesem Zweck wird an der Schaufelspitze 4 eine Schaufelspitzenpanzerung vorgesehen (siehe Fig. 3), die auch eine Schneidfunktion aufweist, sodass sich die Schaufelspitze 4 in ein umgebendes Strömungskanalgehäuse beziehungsweise daran angeordnetes Dichtungsmaterial einschneiden kann. Beispielsweise kann die Schaufelspitzenpanzerung durch eine Beschichtung mit einer Nickel - Matrix 6 mit eingelagerten, kubischen Bornitrid - Partikeln 7 gebildet sein.

Das Schaufelblatt 3 weist ebenfalls zum Schutz der Schaufel 1 eine Beschichtung auf, nämlich eine Erosionsschutzbeschichtung, die das Material der Schaufel 1 vor Erosionsverschleiß schützen soll. Eine derartige Erosionsschutzbeschichtung kann aus einer sogenannten Multi - Layer - Schicht beziehungsweise Mehrlagen - Schicht bestehen, die aus einer Vielzahl von alternierend abgeschiedenen harten und weichen Schichten, insbesondere Keramikschichten und Metallschichten, bestehen kann.

In Figur 1 ist weiterhin gezeigt, dass zur Aufbringung einer Erosionsschutzschicht, die im Wesentlichen auf den Schaufelblättern sowie an der Eintrittskante 8 und der Austrittskante 9 der Schaufel abgeschieden werden soll, der Bereich der Schaufelspitze 4 durch eine Maske 10 abgedeckt wird, welche durch zwei Stützen 11,12, die im Bericht der Eintrittskante 8 und der Austrittskante 9 angordnet sind, gehalten wird.

Wie die schematische Darstellung der Figur 1 zeigt, ist die Maske 10 im Abstand zur Schaufelspitze 4 angeordnet, wobei der Abstand sehr klein gewählt werden kann.

Die Maske 10 ist entsprechend der Form der Schaufelspitze 4 ausgebildet und weist dementsprechend gemäß dem gezeigten Ausführungsbeispiel der Figur 1 ebenfalls eine gebogene Form auf.

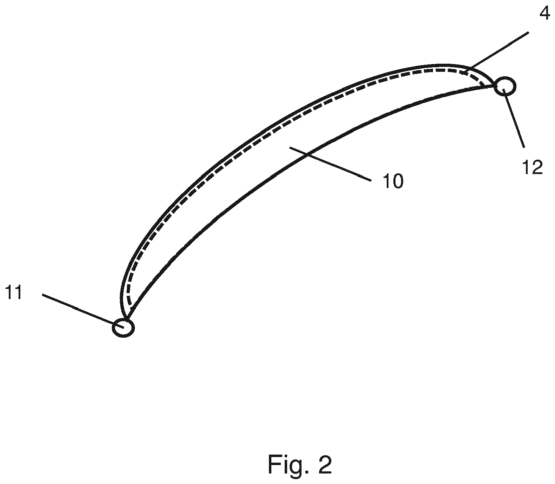

Die Figur 2 zeigt mit einer Draufsicht auf die Schaufel der Figur 1, wobei nur das Schaufelblatt in gestrichelter Darstellung gezeigt ist, die Anordnung der Maske 10 von oben. Es wird deutlich, dass die Maske 10 in ihren Dimensionen und der Form in einer Ebene quer zur radialen Richtung der Schaufel 1 der Gestaltung der Schaufelspitze 4 und insbesondere der Schaufelspitzenoberfläche entspricht. Wie in Figur 2 deutlich zu sehen ist, weist die Maske 10 die gleiche bananenförmige Gestaltung auf, wie die Schaufelspitzenoberfläche der Schaufelspitze 4. Bei der Darstellung der Figur 2 ist die Maske 10 mit einem geringfügigen Überstand ausgebildet, sodass sie etwas größer dimensioniert ist, als die Oberseite der Schaufelspitze 4. Allerdings können die Dimensionen der Maske 10 auch so gewählt werden, dass sie anstelle eines Übermaßes etwas kleiner dimensioniert ist als die Oberfläche der Schaufelspitze 4, je nachdem wie viel Überdeckung der Schaufelspitzenpanzerung 5 mit der Erosionsschutzschicht 13,14 gewünscht ist. Zu diesem Zweck kann auch der Abstand, mit dem die Maske 10 an der Schaufelspitze 4 angeordnet ist, variiert werden, wobei im Extremfall auch in direktes Aufliegen der Maske 10 auf der Schaufelspitze 4 möglich ist.

Die Figur 3 zeigt in den Teilbildern a) bis e) die verschiedenen Stadien bei der Herstellung einer Schaufel mit einer Schaufelspitzenpanzerung an der Schaufelspitze 4 und eine Erosionsschutzbeschichtung an dem Schaufelblatt 3. In Teilbild a) der Figur 2 ist ein Teil einer Schaufel 1 mit dem Schaufelblatt 3 und der Schaufelspitze 4 gezeigt.

Auf die Schaufelspitze 4 wird gemäß Figur 3 b) eine Schaufelspitzenpanzerung 5 aufgebracht, die aus einer Nickel - Matrix 6 und darin eingelagerten Partikeln 7 aus kubischem Bornitrid besteht. Die Aufbringung der Schaufelspitzenpanzerung 5 erfolgt beispielsweise durch galvanische Abscheidung der Nickel - Matrix 6, in welche die kubischen Bornitrid - Partikel eingelagert werden. Die Schaufelspitzenpanzerung kann jedoch auch auf andere geeignete Weise erfolgen.

Nachdem die Schaufelspitzenpanzerung 5 fertiggestellt ist, wird die Maske 10 angeordnet, um die Erosionsschutzschicht 13,14 aufbringen zu können (siehe Fig. 3 c)).

Die Erosionsschutzschicht 13,14 kann durch physikalische Dampfphasenabscheidung (PVD physical vapor deposition) abgeschieden werden und zwar insbesondere durch verschiedene Verfahren des Aufdampfens oder des Aufbringens der entsprechenden Partialschichten der Multi - Layer - Erosionsschutzschicht durch Zerstäuben (Sputtern). Dabei erfolgt eine vollflächige Beschichtung der Schaufel 1 sowohl am Schaufelblatt 3 als auch an der Schaufelspitze 4 oberhalb der Schaufelspitzenpanzerung 5. Allerdings ist die Abscheidung der Erosionsschutzschicht im Bereich der Schaufelspitze 4 durch die Maske 10 reduziert, sodass sich eine dünnere Erosionsschutzschicht 14 im Vergleich zu der dickeren Erosionsschutzschicht 13 im Bereich des Schaufelblatts 3 ergibt (siehe Figur 3 d)). Insbesondere ist die Dicke der Erosionsschutzschicht 14 im Bereich der Schaufelspitze 4 so gering, dass die in der Spitzenpanzerung eingelagerten Hartstoffpartikel in Form der Bornitrid - Partikel 7 aus der Erosionsschutzschicht 14 hervorstehen. Die dünne Erosionsschutzschicht 14 im Bereich der Schaufelspitze 4 bzw. der Schaufelspitzenpanzerung 5 ist jedenfalls so dünn, dass sie die Schneidwirkung der Harstoffpartikel bzw. BN - Partikel 7 nicht beeinträchtigt.

Nach der Abscheidung der Erosionsschutzschicht 13,14 wird die Maske 10 mit den sie haltenden Stützen 11,12 entfernt, sodass eine Schaufel 1 mit einer dickeren Erosionsschutzschicht 13 im Bereich des Schaufelblatts und eine dünnere Erosionsschutzschicht 14 im Bereich der Schaufelspitze bzw. der Schaufelspitzenpanzerung 5 vorliegt, wobei sich die relativen Angaben dicker oder dünner jeweils auf den anderen Teil der Erosionsschutzschicht 13,14 beziehen.

Die Schaufelspitzenpanzerung 5 ist in die benachbarte Erosionsschutzschicht 10 eingebettet und wird von dieser umgeben, ohne die Schleiffläche der Schaufelspitzenpanzerung 5, die in Kontakt mit einem gegenüberliegenden Dichtungsmaterial gelangt, zu stark zu überdecken.

Obwohl die vorliegende Erfindung anhand der gezeigten Ausführungsbeispiele deutlich beschrieben worden ist, ist die Erfindung nicht auf diese Ausführungsbeispiele beschränkt, sondern vielmehr sind Abwandlungen in der Weise möglich, dass einzelne Merkmale weggelassen oder andersartige Kombinationen von Merkmalen verwirklicht werden können, solange der Schutzbereich der beigefügten Ansprüche nicht verlassen wird.

### BEZUGSZEICHENLISTE

- 1: Schaufel
- 2: Schaufelfuß
- 3: Schaufelblatt
- 4: Schaufelspitze
- 5: Schaufelspitzenpanzerung
- 6: Ni - Matrix
- 7: BN - Partikel
- 8: Eintrittskante
- 9: Austrittskante
- 10: Maske
- 11,12: Stütze
- 13: Erosionsschutzschicht am Schaufelblatt
- 14: Erosionsschutzschicht im Bereich der Schaufelspitze

## Patentansprüche

1. Verfahren zur Herstellung einer Schaufel (1) für eine Strömungsmaschine, wobei die Schaufel an ihrer Schaufelspitze (4) eine Schaufelspitzenpanzerung (5) und zumindest an ihrem Schaufelblatt (3) eine Erosionsschutzschicht (10) aufweist,
**dadurch gekennzeichnet, dass**
zunächst eine Schaufelspitzenpanzerung (5) an der Schaufelspitze aufgebracht wird, anschließend im Bereich der Schaufelspitzenpanzerung eine Maske (10) angeordnet wird, die die Schaufelspitzenpanzerung abdeckt, und nachfolgend die Erosionsschutzschicht (13, 14) abgeschieden wird, wobei die Maske nach Fertigstellung der Erosionsschutzschicht wieder entfernt wird, wobei die Maske (10) im Abstand zur Schaufelspitzenpanzerung (5) angeordnet wird und der Form der Schaufelspitzenpanzerung nachgebildet ist.

2. Verfahren nach Anspruch 1,
**dadurch gekennzeichnet, dass**
die Maske (10) der Form der Schaufelspitzenpanzerung in einer dreidimensionalen Nachbildung der Oberflächenform der Schaufelspitzenpanzerung oder in einer zweidimensionalen Projektion der Oberflächenform der Schaufelspitzenpanzerung nachgebildet ist.

3. Verfahren nach einem der vorhergehenden Ansprüche,
**dadurch gekennzeichnet, dass**
die Maske (10) im Bereich einer Eintrittskante (8) und/oder einer Austrittskante (9) der Schaufel gelagert ist.

4. Verfahren nach einem der vorhergehenden Ansprüche,
**dadurch gekennzeichnet, dass**
die Maske (10) in einem generativen Herstellungsverfahren hergestellt wird.

5. Verfahren nach einem der vorhergehenden Ansprüche,
**dadurch gekennzeichnet, dass**
die Maske (10) so dimensioniert ist, dass sie bei der nachfolgenden Abscheidung der Erosionsschutzschicht (13, 14) formstabil ist.

6. Verfahren nach einem der vorhergehenden Ansprüche,
**dadurch gekennzeichnet, dass**
die Maske (10) so dimensioniert und/oder angeordnet ist, dass die Abscheidung der Erosionsschutzschicht im Bereich der Schaufelspitzenpanzerung so reduziert wird, dass die maximale oder mittlere Dicke der Erosionsschutzschicht (13) im Bereich der Schaufelspitzenpanzerung kleiner als die Hälfte, vorzugsweise kleiner oder gleich einem Drittel, insbesondere kleiner oder gleich 10 % der mittleren Dicke der übrigen Erosionsschutzschicht (14) beträgt.

7. Verfahren nach einem der vorhergehenden Ansprüche,
**dadurch gekennzeichnet, dass**
die Aufbringung der Schaufelspitzenpanzerung (5) durch einen Prozess aus der Gruppe erfolgt, die galvanisches Abscheiden, insbesondere einer Nickel - Matrix (6), mit eingelagerten Hartstoffpartikeln (7), insbesondere Partikeln aus Bornitrid, Auflöten und/oder Aufbringen einer Schlickerschicht umfasst.

8. Verfahren nach einem der vorhergehenden Ansprüche,
**dadurch gekennzeichnet, dass**
die Erosionsschutzschicht (13, 14) durch physikalische Dampfphasenabscheidung abgeschieden wird, insbesondere mit einem Prozess aus der Gruppe, die Aufdampfen, Lichtbogenverdampfen, Elektronenstrahlverdampfen, Zerstäuben und Magnetron - Sputtern umfasst.

## Claims

1. Method for producing a blade (1) for a turbomachine, the blade having blade-tip armoring (5) on the blade tip (4) thereof, and an erosion-protection layer (10) at least on the airfoil (3) thereof,
**characterized in that**
firstly, blade-tip armoring (5) is applied to the blade tip, then a mask (10) is arranged in the region of the blade-tip armoring which covers the blade-tip armoring, and subsequently the erosion-protection layer (13, 14) is deposited, the mask being removed again after the erosion-protection layer has been completed, the mask (10) being arranged at a distance from the blade-tip armoring (5) and simulating the shape of the blade-tip armoring.

2. Method according to claim 1,
**characterized in that**
the mask (10) simulates the shape of the blade-tip armoring in a three-dimensional simulation of the surface shape of the blade-tip armoring or in a two-dimensional projection of the surface shape of the blade-tip armoring.

3. Method according to either of the preceding claims,
**characterized in that**
the mask (10) is mounted in the region of a leading edge (8) and/or a trailing edge (9) of the blade.

4. Method according to any of the preceding claims,
**characterized in that**
the mask (10) is produced in an additive manufacturing process.

5. Method according to any of the preceding claims,
**characterized in that**
the mask (10) is dimensioned such that it is dimensionally stable during the subsequent deposition of the erosion-protection layer (13, 14).

6. Method according to any of the preceding claims,
**characterized in that**
the mask (10) is dimensioned and/or arranged such that the deposition of the erosion-protection layer in the region of the blade-tip armoring is reduced such that the maximum or average thickness of the erosion-protection layer (13) in the region of the blade-tip armoring is less than half, preferably less than or equal to one third, in particular less than or equal to 10% of the average thickness of the remaining erosion-protection layer (14).

7. Method according to any of the preceding claims,
**characterized in that**
the blade-tip armoring (5) is applied by means of a process from the group comprising electrodeposition, in particular of a nickel matrix (6) having embedded hard material particles (7), in particular particles made of boron nitride, and soldering and/or applying a slip layer.

8. Method according to any of the preceding claims,
**characterized in that**
the erosion protection layer (13, 14) is deposited by physical vapor phase deposition, in particular using a process from the group comprising evaporation, arc evaporation, electron beam evaporation, atomization and magnetron sputtering.

## Revendications

1. Procédé de production d'une aube (1) pour une turbomachine, selon lequel l'aube comporte un blindage d'extrémité d'aubes (5) à son extrémité d'aube (4), et présente au moins une couche de protection contre l'érosion (10) sur sa pale d'aube (3),
**caractérisé en ce que,**
tout d'abord, un blindage d'extrémité d'aubes (5) est appliqué sur l'extrémité d'aube, puis un masque (10) est disposé au niveau du blindage d'extrémité d'aubes, lequel masque recouvre le blindage d'extrémité d'aubes, ensuite la couche de protection contre l'érosion (13, 14) est déposée, le masque étant à nouveau retiré après la réalisation de la couche de protection contre l'érosion, le masque (10) étant disposé à distance du blindage d'extrémité d'aubes (5) et reproduisant la forme du blindage d'extrémité d'aubes.

2. Procédé selon la revendication 1,
**caractérisé en ce que**
le masque (10) de la forme du blindage d'extrémité d'aubes est reproduit dans une réplique tridimensionnelle de la forme de surface du blindage d'extrémité d'aubes ou dans une projection bidimensionnelle de la forme de surface du blindage d'extrémité d'aubes.

3. Procédé selon l'une des revendications précédentes,
**caractérisé en ce que**
le masque (10) est monté au niveau d'un bord d'entrée (8) et/ou d'un bord de sortie (9) de l'aube.

4. Procédé selon l'une des revendications précédentes,
**caractérisé en ce que**
le masque (10) est produit dans un procédé de production générative.

5. Procédé selon l'une des revendications précédentes,
**caractérisé en ce que**
le masque (10) est dimensionné de telle sorte qu'il est indéformable lors du dépôt ultérieur de la couche de protection contre l'érosion (13, 14).

6. Procédé selon l'une des revendications précédentes,
**caractérisé en ce que**
le masque (10) est dimensionné et/ou disposé de telle sorte que le dépôt de la couche de protection contre l'érosion au niveau du blindage d'extrémité d'aubes est réduit de manière à ce que l'épaisseur maximale ou moyenne de la couche de protection contre l'érosion (13) au niveau du blindage d'extrémité d'aubes soit inférieure à la moitié, de préférence inférieure ou égale à un tiers, en particulier inférieure ou égale à 10 % de l'épaisseur moyenne de la couche de protection contre l'érosion (14) restante.

7. Procédé selon l'une des revendications précédentes,
**caractérisé en ce que**
l'application du blindage d'extrémité d'aubes (5) est effectuée par un procédé choisi dans le groupe comprenant le dépôt galvanique, en particulier d'une matrice de nickel (6), avec des particules de matériau dur enrobées (7), en particulier des particules de nitrure de bore, le brasage et/ou l'application d'une couche de barbotine.

8. Procédé selon l'une des revendications précédentes,
**caractérisé en ce que**
la couche de protection contre l'érosion (13, 14) est déposée par dépôt physique en phase vapeur, en particulier en utilisant un procédé choisi dans le groupe comprenant l'évaporation, l'évaporation par arc électrique, l'évaporation par faisceau d'électrons, l'atomisation et la pulvérisation par magnétron.
